# EUROPEAN PATENT APPLICATION

(11) **EP 4 804 745 A1**
(43) Date of publication of application: **09.09.2026**
(21) Application number: 26161716.1
(22) Date of filing: 02.03.2026
(51) Int. Cl.: H05K 7/14

(54) **NETWORK CONTROL UNIT TRAY**

(30) Priority: 03.03.2025 US 202563765911 P
(71) Applicant: Vertiv Corporation, Westerville, OH 43082 (US)
(72) Inventor: BHILARE, Prashant Dhondiba, Westerville, 43082 (US); BATTISE, Diksha, Westerville, 43082 (US); VHATTE, Yogesh, Westerville, 43082 (US); SAM, Yahya, Westerville, 43082 (US)
(74) Representative: Cousens, Nico

(57) **Abstract**

A system includes: a network control unit shelf; a network control unit tray disposed on a first side of the network control unit shelf; a network control unit secured to the network control unit tray; a printed circuit board assembly secured to the network control unit tray; and at least one tray rail, wherein the network control unit tray is configured to slide along at least a portion of the at least one tray rail.

## Description

This Application claims priority to U.S. Provisional Patent Application No. 63/765,911, filed March 3, 2025.

### TECHNICAL FIELD

This disclosure relates to network control unit shelves, and, in particular to an improved, scalable, cost-efficient, network control unit tray design debugging purposes and optimized for wire management and scalable, and reduced production complexity.

### BACKGROUND

Network control unit (NCU) shelves (or equipment) are typically used to control and/or to monitor parameters inside direct current (DC) and alternating current (AC) power systems, while, typically, allowing for fans and airflow, low voltage disconnect (LVD) disconnection, varying alarm signals, digital input and output signals, programmable logic controller (PLC) functionality, and/or the like. Current NCU shelf designs face challenges in NCU control, wire harness assembly, and contactor tray movement (e.g., while a contractor is debugging and/or connecting wires).

Bulky wire bundles obstruct ventilation slots and limit bending radius, causing strain on the wires and difficulty in lug installation. Controller wires, sandwiched between the tray and sidewall, risk damage during tray operation. Routing these wires takes a skilled worker a relatively long time, creating a bottleneck in mass production. Such NCU designs are inefficient and prone to damage, requiring improvements for better assembly efficiency and durability.

Additionally, in the current NCU shelf design, space limitations make it difficult to access the NCU and its control wiring. The NCU and its interconnection connector are challenging enough to reach in the event of a site failure, making fault debugging a tedious process. Removing the NCU shelf from the system is complex, and if the interconnection connector or its wiring fails on-site, it requires a complete system disassembly.

### SUMMARY

An aspect of the disclosed embodiment includes a system that includes a network control unit that includes at least one tray configured to integrate a printed circuit board assembly and to provide improved wire management.

Another aspect of the disclosed embodiments includes a system that includes: a network control unit shelf; a network control unit tray disposed on a first side of the network control unit shelf; a network control unit secured to the network control unit tray; a printed circuit board assembly secured to the network control unit tray; and at least one tray rail, wherein the network control unit tray is configured to slide along at least a portion of the at least one tray rail.

These and other aspects of the disclosed embodiments are descried herein.

### BRIEF DESCRIPTION OF THE DRAWINGS

The disclosure is best understood from the following detailed description when read in conjunction with the accompanying drawings. It is emphasized that, according to common practice, the various features of the drawings are not to-scale. On the contrary, the dimensions of the various features are arbitrarily expanded or reduced for clarity.
FIG. 1 generally illustrates an NCU shelf according to the principles of the present disclosure.
FIG. 2 generally illustrates an alternative NCU shelf according to the principes of the present.
FIGS. 3A and 3B generally illustrate an NCU tray according to the principles of the present disclosure.
FIG. 4 generally illustrates a NCU tray extended or slid out from an NCU shelf according to the principles of the present disclosure.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be described herein in detail.

It may be understood that the example embodiments described herein may be considered in a descriptive sense only and not for purposes of limitation. Descriptions of features or aspects within each example embodiment may be considered as available for other similar features or aspects in other example embodiments.

As described, NCU shelves are typically used to control and to view DC or AC power system parameters. Such parameters may include voltage, current, and/or other suitable parameters. Additionally, or alternatively, NCU shelves may be used to monitor DC or AC Power status in a relatively secure manner.

Current NCU shelf designs face challenges in wire harness assembly and tray movement. Bulky wire bundles obstruct ventilation slots and limit bending radius, causing strain on the wires and difficulty in lug installation. Controller wires, sandwiched between the tray and sidewall, risk damage during tray operation. Such designs are inefficient and prone to damage, requiring improvements for better assembly efficiency and durability. Further, typical NCU designs are tedious to use and not suitable for mass production.

Accordingly, systems and methods, such as the systems and methods described herein, configured to provide an improved NCU tray, may be desirable. In some embodiments, the systems and methods described herein may be configured to provide a movable NCU tray arrangement within the NCU shelf, which allows for easy access to the NCU and associated wires. The systems and methods described herein may be configured to simplify the replacement, wiring, and maintenance of the NCU and interconnection printed circuit board assembly (PCBA) on-site, significantly improving serviceability, while minimizing downtime. The systems and methods described herein may be configured to reduce NCU harness assembly time, which may improve production times. The systems and methods described herein may be configured to accommodate any suitable power system.

The systems and methods described herein may be configured to improved cost efficiency (e.g., using fewer wires and connectors, which lowers material costs). The systems and methods described herein may be configured to provide faster assembly, using a simplified design, which increasing production speed, crucial for mass manufacturing.

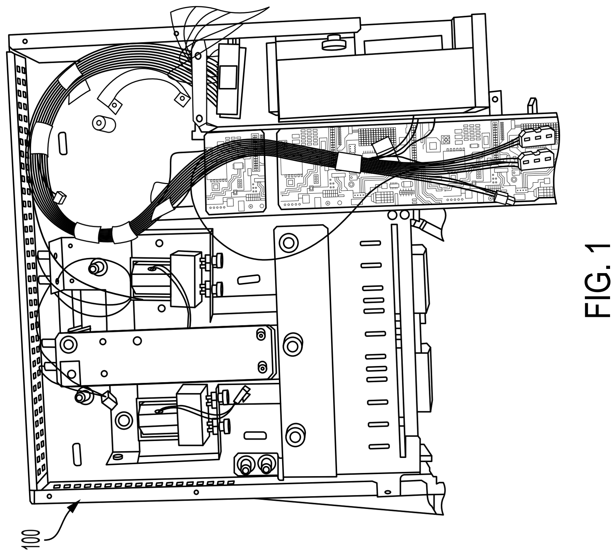

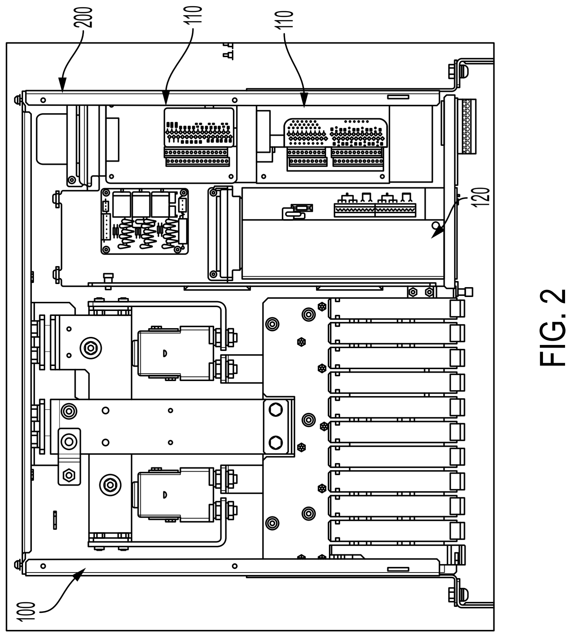

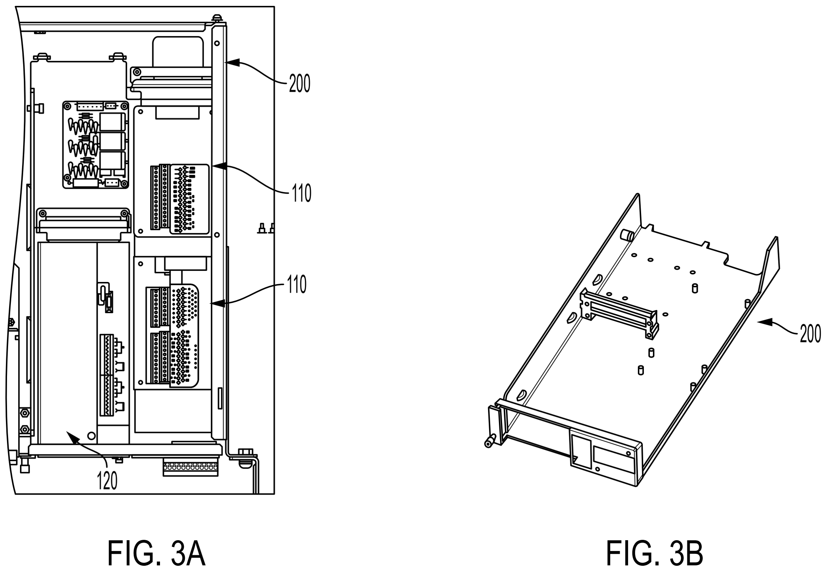

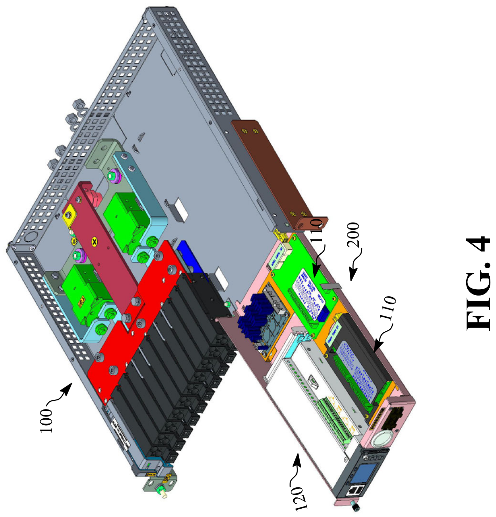

FIGS. 1-4 generally illustrate an NCU shelf 100 and an NCU tray 200, according to the principles of the present disclosure. In some embodiments, the NCU tray 100 may include the NCU tray 200, which may secure an NCU 120 and integrate one or more PCBAs 110 on the NCU tray 200 (e.g., which may include one or more customer or user interface PCBAs). It should be understood that the systems and methods described herein may be applied to any other PCB type and can be used in the DC power system as a user interface board to, for example, improve access to wiring and terminals for any connection.

In some embodiments, the NCU tray 200 may be disposed on a first side of the NCU shelf 100. The NCU 120 may be secured to the NCU tray 200. Additionally, or alternatively, the one ore more PCBAs 100 may be secured to the NCU tray 200.

The NCU shelf 100 may be stationary and disposed or secured to rack of a data center (e.g., or other suitable rack or location). The NCU shelf 100 may include at least one tray rail configured allow the NCU tray 200 to slide or move relative to the NCU shelf 100.

In some embodiments, the NCU tray 200 may be configured to engage at least one pin connector (e.g., for access during operation of the NCU 120). The NCU tray 200 may include at least one wiring harness that includes one or more wires connecting the NCU 120 and/or the one or more PCBAs 110 to one or more other components, which may be disposed on the NCU shelf 100 or remotely located from the NCU shelf 100. The at least one wiring harness may include a flexible wiring harness or other suitable wiring harness. The at least one wiring harness may be configured to allow the NCU tray 200 to move relative to the NCU shelf 100 without disconnection of the one or more wires.

In some embodiments, the NCU tray 200 may include includes one or more service loops configured to guide the one or more wires associated with the NCU tray 200 and facilitate movement of the NCU tray 200 without disconnection of the one or more wires.

The NCU tray 200 may include a layout that significantly reduces the wire bundle, allowing for easy tray movement without risking wire damage. The NCU tray 200 may include fewer (e.g., relative to other NCU trays) wires and connectors, which may result in cost savings. The NCU tray 200 may provide a streamlined design that eliminates the need for skilled labor assistance. The NCU tray 200 may be configured for relatively quick and efficient assembly, reducing overall time and effort. The NCU tray 200 may engage the NCU 120 continuously while in service (e.g., lowering the probability of removing NCU 120 from an associated system while debugging, and allowing for a production test and service engineer to troubleshoot a problem with the NCU 120 powered ON in most circumstances).

The systems and methods described herein may be configured to provide an improved NCU tray design by providing an optimized layout that reduces wire clutter and enhances NCU tray functionality. The NCU tray 200 may include improved wire management, which reduces wire damage, improving reliability and assembly efficiency. The NCU tray 200 may enhance ventilation, including clear airflow, which improves thermal management.

The NCU tray 200 provides improved durability, minimizing risks of wire damage during tray operations. The NCU tray 200 may be configured for a labor-free assembly, using a streamlined design, which eliminates the need for skilled labor. The NCU tray 200 may include a modular design (e.g., simplified for easier upgrades and maintenance). The NCU tray 200 may allow for relatively easier daily work for users on site to connect any signal wires or to maintain the existing connection.

The NCU tray 200 may be scalable for mass production (e.g., suitable for efficient, large-scale manufacturing). The NCU tray 200 may be configured to provide sustainability (e.g., eco-friendly with fewer materials and faster assembly). The NCU tray 200 may be configured to provide reduced labor and materials, which may lower production costs. The NCU tray 200 may provide production efficiency (e.g., using a streamlined design accelerates assembly, cutting costs and boosting scalability for mass production).

In some embodiments, a system includes: a network control unit shelf; a network control unit tray disposed on a first side of the network control unit shelf; a network control unit secured to the network control unit tray; a printed circuit board assembly secured to the network control unit tray; and at least one tray rail, wherein the network control unit tray is configured to slide along at least a portion of the at least one tray rail.

In some embodiments, the network control unit shelf is stationary. In some embodiments, the network control unit tray moveable relative to the network control unit shelf. In some embodiments, the network control unit shelf is secured to a portion of datacenter rack. In some embodiments, the printed circuit board assembly includes a user interface printed circuit board assembly. In some embodiments, the network control unit tray is configured to engage at least one pin connector. In some embodiments, the system also includes at least one wiring harness. In some embodiments, one or more wires of the at least one wiring harness connects the network control unit to at least one other component. In some embodiments, the at least one other component is disposed on the network control unit shelf. In some embodiments, the at least one other component is not disposed on the network control unit shelf. In some embodiments, one or more wires of the at least one wiring harness connects the printed circuit board assembly to at least one other component. In some embodiments, the at least one other component is disposed on the network control unit shelf. In some embodiments, the at least one other component is not disposed on the network control unit shelf. In some embodiments, the at least one wiring harness includes a flexible wiring harness. In some embodiments, the at least one wiring harness is configured to allow the network control unit tray to move relative to the network control unit shelf without disconnection of one or more wires of the at least one wiring harness. In some embodiments, the network control unit tray is moveable relative to the network control unit shelf during operation of the network control unit. In some embodiments, the system also includes one or more other printed circuit board assemblies. In some embodiments, the one or more other printed circuit board assemblies are secured to the network control unit tray. In some embodiments, the network control unit tray includes one or more service loops. In some embodiments, the one or more service loops guide one or more wires associated with the network control unit tray and facilitate movement of the network control unit tray without disconnection of the one or more wires.

While example embodiments have been described with reference to the figures, it will be understood by those of ordinary skill in the art that various changes in form and details may be made therein without departing from the scope as defined by the following claims.

## Claims

1. A system comprising:
a network control unit shelf (100);
a network control unit tray (200) disposed on a side of the network control unit shelf;
a network control unit (120) secured to the network control unit tray;
a printed circuit board assembly (110) secured to the network control unit tray; and
at least one tray rail, wherein the network control unit tray is configured to slide along at least a portion of the at least one tray rail.

2. The system of claim 1, wherein the network control unit shelf is stationary.

3. The system of claim 2, wherein the network control unit tray is moveable relative to the network control unit shelf.

4. The system of claim 2 or 3, wherein the network control unit shelf is secured to a portion of a data center rack.

5. The system of any preceding claim, wherein the printed circuit board assembly includes a user interface printed circuit board assembly.

6. The system of any preceding claim, wherein the network control unit tray is configured to engage at least one pin connector.

7. The system of any preceding claim, further comprising at least one wiring harness.

8. The system of claim 7, wherein one or more wires of the at least one wiring harness connects the network control unit to at least one other component.

9. The system of claim 8, wherein the at least one other component is disposed on the network control unit shelf, or wherein the at least one other component is not disposed on the network control unit shelf.

10. The system of any of claims 7 to 9, wherein one or more wires of the at least one wiring harness connects the printed circuit board assembly to at least one other component.

11. The system of claim 10, wherein the at least one other component is disposed on the network control unit shelf or wherein the at least one other component is not disposed on the network control unit shelf.

12. The system of any of claims 7 to 11, wherein the at least one wiring harness includes a flexible wiring harness, and/or wherein the at least one wiring harness is configured to allow the network control unit tray to move relative to the network control unit shelf without disconnection of one or more wires of the at least one wiring harness.

13. The system of claims 1 or 5 to 12 when not dependent on claim 2, wherein the network control unit tray is moveable relative to the network control unit shelf during operation of the network control unit.

14. The system of any preceding claim, further comprising one or more other printed circuit board assemblies, and optionally wherein the one or more other printed circuit board assemblies are secured to the network control unit tray.

15. The system of any preceding claim, wherein the network control unit tray includes one or more service loops, and optionally wherein the one or more service loops guide one or more wires associated with the network control unit tray and facilitate movement of the network control unit tray without disconnection of the one or more wires.
